# EUROPEAN PATENT APPLICATION

(11) **EP 4 513 574 A1**
(43) Date of publication of application: **26.02.2025**
(21) Application number: 22942396.7
(22) Date of filing: 30.09.2022
(51) Int. Cl.: H01L 31/0224, H01L 31/0236, H01L 31/0747, H01L 31/18, H01L 31/20

(54) **HETEROJUNCTION BATTERY AND PREPARATION METHOD THEREFOR**

(30) Priority: 16.05.2022 CN 202210530719
(71) Applicant: Risen Energy Co. Ltd, Ningbo Zhejiang 315600 (CN)
(72) Inventor: LIU, Lin, Ningbo, Zhejiang 315600 (CN); ZHAO, Feng, Ningbo, Zhejiang 315600 (CN); REN, Mingchong, Ningbo, Zhejiang 315600 (CN); YANG, Bochuan, Ningbo, Zhejiang 315600 (CN)
(74) Representative: Murgitroyd & Company
(86) International application number: PCT/CN2022/123404
(87) International publication number: WO 2023/221369

(57) **Abstract**

A heterojunction battery and a preparation method therefor are provided. The heterojunction battery includes a crystalline silicon layer (1), a first intrinsic amorphous silicon layer (2), an N-type doped amorphous silicon layer (3), a first transparent conductive layer (4), and a first metal electrode (5) are sequentially arranged on a front surface of the crystalline silicon layer (1) from inside to outside, and a second intrinsic amorphous silicon layer (6), a P-type doped amorphous silicon layer (7), a second transparent conductive layer (8), and a second metal electrode (9) are sequentially arranged on a back surface of the crystalline silicon layer (1) from inside to outside. A local reduction layer (10) is formed on a surface of the first transparent conductive layer (4) that is under the first metal electrode (5) and/or on a surface of the second transparent conductive layer (8) that is under the second metal electrode (9).

## Description

### CROSS-REFERENCE TO RELATED APPLICATION

This application claims priority to Chinese patent application No. 202210530719.0, filed on May 16, 2022, titled "HETEROJUNCTION BATTERY AND PREPARATION METHOD THEREFOR", the content of which is hereby incorporated herein in its entirety by reference.

### TECHNICAL FIELD

The present invention generally relates to the field of a heterojunction battery, and in particular, to a heterojunction battery and a preparation method therefor.

### BACKGROUND

Monocrystalline silicon heterojunction solar cells have high conversion efficiency and are recognized by the photovoltaic industry as one of key technologies for large-scale industrialization of the next generation.

A silicon-based heterojunction solar cell is generally formed by a N-type monocrystalline silicon wafer with a double-sided pyramid textured morphology. An intrinsic amorphous silicon layer and an N-type doped amorphous silicon layer are deposited on a front side of the silicon wafer, an intrinsic amorphous silicon layer and a P-type doped amorphous silicon layer are deposited on a back side of the silicon wafer, and then transparent conductive films and metal electrodes are formed on both sides of the silicon wafer.

In the related art, a transparent conductive layer is susceptible to adsorption of water vapor, oxygen, and organic in the air, which causes poor contact performance between the transparent conductive layer and a cryogenic slurry, and increases contact resistance, resulting in low battery efficiency.

### SUMMARY

According to various embodiments of the present invention, a heterojunction battery is provided, including a crystalline silicon layer. A first intrinsic amorphous silicon layer, a N-type doped amorphous silicon layer, a first transparent conductive layer, and a first metal electrode are sequentially arranged on a front surface of the crystalline silicon layer from inside to outside. A second intrinsic amorphous silicon layer, a P-type doped amorphous silicon layer, a second transparent conductive layer, and a second metal electrode are sequentially arranged on a back surface of the crystalline silicon layer from inside to outside. A local reduction layer is formed on either or both of a surface of the first transparent conductive layer that is under the first metal electrode and a surface of the second transparent conductive layer that is under the second metal electrode. A carrier concentration of the local reduction layer is greater than that of either or both of the first transparent conductive layer and the second transparent conductive layer.

In some embodiments, a width of the local reduction layer is in a range of 5 µm to 50 µm.

In some embodiments, the crystalline silicon layer includes N-type doped monocrystalline silicon, N-type doped quasi monocrystalline silicon, P-type doped monocrystalline silicon, or P-type doped quasi monocrystalline silicon, and a thickness of the crystalline silicon layer is in a range of 50 µm to 250 µm.

In some embodiments, the first intrinsic amorphous silicon layer includes an undoped amorphous silicon semiconductor film, an amorphous silicon oxide semiconductor film, an amorphous silicon carbide semiconductor film, or a composite film layer formed by a combination thereof, and a thickness of the first intrinsic amorphous silicon layer is in a range of 2 nm to 8 nm.

In some embodiments, the N-type doped amorphous silicon layer includes a N-type doped amorphous silicon semiconductor film, a N-type doped amorphous silicon oxide semiconductor film, a N-type doped amorphous silicon carbide semiconductor film, a N-type doped microcrystalline silicon semiconductor film, a N-type doped microcrystalline silicon oxide semiconductor film, a N-type doped microcrystalline silicon carbide semiconductor film, or a composite film layer formed by a combination thereof, and a thickness of the N-type doped amorphous silicon layer is in a range of 4 nm to 30 nm.

In some embodiments, the P-type doped amorphous silicon layer includes a P-type doped amorphous silicon semiconductor film, a P-type doped amorphous silicon oxide semiconductor film, a P-type doped amorphous silicon carbide semiconductor film, a P-type doped microcrystalline silicon semiconductor film, a P-type doped microcrystalline silicon oxide semiconductor film, a P-type doped microcrystalline silicon carbide semiconductor film, or a composite film layer formed by a combination thereof, and a thickness of the P-type doped amorphous silicon layer is in a range of 4 nm to 30 nm.

In some embodiments, the first transparent conductive layer includes a doped indium oxide film, a doped zinc oxide film, a doped tin oxide film, or a composite film layer formed by a combination thereof, and a thickness of the first transparent conductive layer is in a range of 70 nm to 120 nm. The second transparent conductive layer includes a doped indium oxide film, a doped zinc oxide film, a doped tin oxide film, or a composite film layer formed by a combination thereof, and a thickness of the second transparent conductive layer is in a range of 70 nm to 120 nm.

In some embodiments, both the first transparent conductive layer and the second transparent conductive layer are ITO (indium tin oxide) transparent conductive films, a mass percentage of indium elements in the first transparent conductive layer and the second transparent conductive layer each is 90%, and a mass percentage of tin elements in the first transparent conductive layer and the second transparent conductive layer each is 10%.

In some embodiments, the first metal electrode includes a cryogenic metal slurry electrode containing Ag, Cu, Al, Ni or a combination thereof, a thickness of the first metal electrode is in a range of 10 µm to 50 µm, and a width of the first metal electrode is in a range of 5 µm to 50 µm. The second metal electrode includes a cryogenic metal slurry electrode containing Ag, Cu, Al, Ni or a combination thereof, a thickness of the second metal electrode is in a range of 10 µm to 50 µm, and a width of the second metal electrode is in a range of 5 µm to 50 µm.

A preparation method for the above heterojunction battery is further provided in the present invention, including step one to step six.

Step one includes that providing a crystalline silicon layer.

Step two includes that texturing a surface of the crystalline silicon layer, and cleaning the surface of the crystal silicon layer.

Step three includes that depositing the first intrinsic amorphous silicon and the N-type doped amorphous silicon layer sequentially on the front surface of the crystalline silicon layer obtained in the step two, and depositing the second intrinsic amorphous silicon and the P-type doped amorphous silicon layer sequentially on the back surface of the crystalline silicon layer obtained in the step two.

Step four includes that depositing the first transparent conductive layer on the N-type doped amorphous silicon layer obtained in the step three, and depositing the second transparent conductive layer on the P-type doped amorphous silicon layer obtained in the step three.

Step five includes that placing a mask plate on a surface of either or both of the first transparent conductive layer and the second transparent conductive layer, performing local cleaning and reduction on the transparent conductive layer by hydrogen plasma processing, and obtaining a local reduction layer with relatively increased local carrier concentration. A width of the local reduction layer is in a range of 5 µm to 50 µm.

Step six includes that forming the first metal electrode on the first transparent conductive layer by screen printing, and forming the second metal electrode on the second transparent conductive layer by screen printing. A metal electrode pattern of the first metal electrode and a metal electrode pattern of the second metal electrode are the same as an opening pattern of the mask plate, and either or both of the first metal electrode and the second metal electrode is located at a position directly above the local reduction layer, respectively.

In some embodiments, the mask plate of which the opening pattern is consistent with the metal electrode pattern is disposed on the surface of the transparent conductive layer, and then hydrogen plasma processing is used to perform local cleaning and reduction on the transparent conductive layer, so as to obtain a local reduction layer with relatively increased local carrier concentration.

Details of one or more embodiments of the present invention are set forth in the following accompanying drawings and description. Other features, objectives, and advantages of the present invention become obvious with reference to the description, the accompanying drawings, and the claims.

### BRIEF DESCRIPTION OF THE DRAWINGS

In order to more clearly illustrate the technical solutions in the embodiments of the present invention or the related technology, the accompanying drawings to be used in the description of the embodiments or the related technology will be briefly introduced below, and it will be obvious that the accompanying drawings in the following description are only some of the embodiments of the present invention, and that, for one skilled in the art, other accompanying drawings can be obtained based on these accompanying drawings without putting in creative labor.
FIG. 1 is a schematic diagram of a battery layer in an embodiment of the present invention.

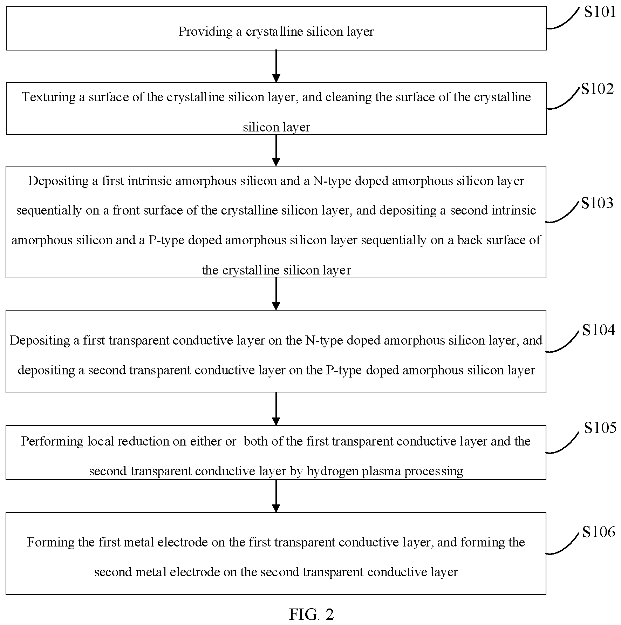

FIG. 2 is a flowchart of a preparation process of a heterojunction battery in an embodiment of the present invention.
In the figures, 1 represents a crystalline silicon layer, 2 represents a first intrinsic amorphous silicon layer, 3 represents a N-type doped amorphous silicon layer, 4 represents a first transparent conductive layer, 5 represents a first metal electrode, 6 represents a second intrinsic amorphous silicon layer, 7 represents a P-type doped amorphous silicon layer, 8 represents a second transparent conductive layer, 9 represents a second metal electrode, and 10 represents a local reduction layer.

### DETAILED DESCRIPTION OF THE EMBODIMENT

To make objectives, technical solutions, and advantages of implementation manners of the present invention clearer, the following clearly and completely describes the technical solutions in the implementation manners of the present invention with reference to the accompanying drawings in the implementation manners of the present invention. Apparently, the described implementation manners are some but not all implementation manners of the present invention. Based on the implementation manners of the present invention, all other implementation manners obtained by one skilled in the art without creative efforts fall within the protection scope of the present invention. Therefore, the following detailed description of the implementation manners of the present invention provided in the accompanying drawings is not intended to limit the scope of the present invention, but merely represents a selected implementation manner of the present invention.

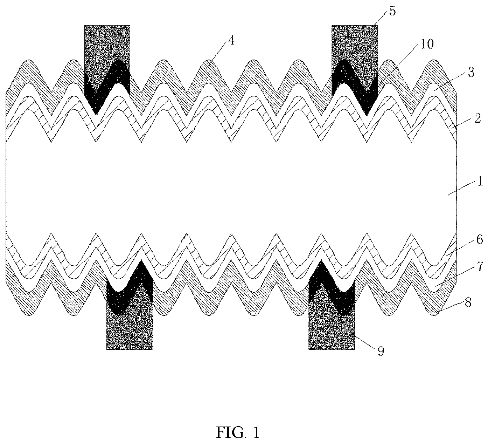

In an embodiment, a local reduction layer is formed on a surface of a transparent conductive layer below a cryogenic metal slurry electrode, local carrier concentration of the transparent conductive layer is increased, and an interface barrier height between the transparent conductive layer and the cryogenic metal slurry electrode is reduced to obtain a relatively low contact resistance. In addition, the locally treated surface is cleaner and is not affected by adsorption of water vapor, oxygen, and organic in the air. Referring to FIG. 1, in some embodiments of the present invention, a heterojunction battery includes a crystalline silicon layer 1. A first intrinsic amorphous silicon layer 2, a N-type doped amorphous silicon layer 3, a first transparent conductive layer 4, and a first metal electrode 5 are sequentially arranged on the front surface of the crystalline silicon layer 1 from inside to outside, and a second intrinsic amorphous silicon layer 6, a P-type doped amorphous silicon layer 7, a second transparent conductive layer 8, and a second metal electrode 9 are sequentially arranged on a back surface of the crystalline silicon layer 1 from inside to outside. A local reduction layer 10 is formed on either or both of a surface of the first transparent conductive layer 4 that is under the first metal electrode 5 and a surface of the second transparent conductive layer 8 that is under the second metal electrode 9. A carrier concentration of the local reduction layer 10 is greater than that of either or both of the first transparent conductive layer and the second transparent conductive layer.

The local reducing layer is arranged on the surface of the transparent conductive layer that is under the metal electrode, the contact resistance between the transparent conductive layer and the metal electrode is reduced, and a battery filling factor and photoelectric conversion efficiency are improved.

In some embodiments, a width of the local reduction layer is in a range of 5 µm to 50 µm.

In some embodiments, the crystalline silicon layer 1 may include N-type doped monocrystalline silicon, N-type doped quasi monocrystalline silicon, P-type doped monocrystalline silicon, or P-type doped quasi monocrystalline silicon, and a thickness of the crystalline silicon layer 1 may be in a range of 50 µm to 250 µm.

In some embodiments, the first intrinsic amorphous silicon layer may include an undoped amorphous silicon semiconductor film, an amorphous silicon oxide semiconductor film, an amorphous silicon carbide semiconductor film, or a composite film layer formed by a combination thereof, and a thickness of the first intrinsic amorphous silicon layer may be in a range of 2 nm to 8 nm.

In some embodiments, the N-type doped amorphous silicon layer may include a N-type doped amorphous silicon semiconductor film, a N-type doped amorphous silicon oxide semiconductor film, a N-type doped amorphous silicon carbide semiconductor film, a N-type doped microcrystalline silicon semiconductor film, a N-type doped microcrystalline silicon oxide semiconductor film, a N-type doped microcrystalline silicon carbide semiconductor film, or a composite film layer formed by a combination thereof, and a thickness of the N-type doped amorphous silicon layer may be in a range of 4 nm to 30 nm.

In some embodiments, the P-type doped amorphous silicon layer may include a P-type doped amorphous silicon semiconductor film, a P-type doped amorphous silicon oxide semiconductor film, a P-type doped amorphous silicon carbide semiconductor film, a P-type doped microcrystalline silicon semiconductor film, a P-type doped microcrystalline silicon oxide semiconductor film, a P-type doped microcrystalline silicon carbide semiconductor film, or a composite film layer formed by a combination thereof, and a thickness of the P-type doped amorphous silicon layer may be in a range of 4 nm to 30 nm.

In some embodiments, the first transparent conductive layer may include a doped indium oxide film, a doped zinc oxide film, a doped tin oxide film, or a composite film layer formed by a combination thereof, and a thickness of the first transparent conductive layer may be in a range of 70 nm to 120 nm. The second transparent conductive layer may include a doped indium oxide film, a doped zinc oxide film, a doped tin oxide film, or a composite film layer formed by a combination thereof, and a thickness of the second transparent conductive layer may be in a range of 70 nm to 120 nm.

In some embodiments, both the first transparent conductive layer and the second transparent conductive layer may be ITO transparent conductive films, a mass percentage of indium elements in the first transparent conductive layer and the second transparent conductive layer each may be 90%, and a mass percentage of tin elements in the first transparent conductive layer and the second transparent conductive layer each may be 10%.

In some embodiments, the first metal electrode may include a cryogenic metal slurry electrode containing Ag, Cu, Al, Ni or a combination thereof, a thickness of the first metal electrode may be in a range of 10 µm to 50 µm, and a width of the first metal electrode may be in a range of 5 µm to 50 µm.The second metal electrode may include a cryogenic metal slurry electrode containing Ag, Cu, Al, Ni or a combination thereof, a thickness of the second metal electrode may be in a range of 10 µm to 50 µm, and a width of the second metal electrode may be in a range of 5 µm to 50 µm.

A preparation method for the above heterojunction battery is further provided in the present invention, including step 101 to step 106.

Step 101 includes that providing a crystalline silicon layer. A N-type straight-pull monocrystalline silicon wafer may be applied, a thickness of the N-type straight-pull monocrystalline silicon wafer may be in a range of 50 µm to 250 µm, a resistivity of the N-type straight-pull monocrystalline silicon wafer may be 3Ω·cm, and a minority carrier life of the N-type straight-pull monocrystalline silicon wafer may be 2000 µs.

Step 102 includes that texturing a surface of the crystalline silicon layer, and cleaning the surface of the crystalline silicon layer. A mixed solution of NaOH with a mass percent of 2% and a texturing additive may be used to texture the silicon wafer, then surface cleaning may be performed on the silicon wafer by a Radio Corporation of America (RCA) standard cleaning method, to remove surface-contaminated impurities, and a surface oxide layer may be removed by a hydrofluoric acid solution with a mass percent of 2%.

Step 103 includes that depositing the first intrinsic amorphous silicon on the front surface of the crystalline silicon layer by a plasma enhanced chemical vapor deposition (PECVD) method, a thickness of the first intrinsic amorphous silicon may be in a range of 2 nm to 8 nm, reactive gas may include SiH₄ and H₂, a flow ratio of H₂ to SiH₄ may be 5 : 1, a power density of a power supply of a PECVD device may be 20 mW/cm², a pressure inside the PECVD device may be 70Pa, and a substrate temperature may be 200 °C. Step 103 further includes that depositing the N-type doped amorphous silicon layer on the first intrinsic amorphous silicon by the PECVD method, a thickness of the N-type doped amorphous silicon layer may be in a range of 4 nm to 30 nm, the reactive gas may include SiH₄, H₂, and PH₃, the flow ratio of H₂ to SiH₄ may be 5 : 1, a flow ratio of PH₃ to SiH₄ may be 0.02, the power density of the power supply of the PECVD device may be 15 mW/cm², the pressure inside the PECVD device may be 80Pa, and the substrate temperature may be 200 °C. Step 103 further includes that depositing the second intrinsic amorphous silicon on the front surface of the crystalline silicon layer by the PECVD method, a thickness of the second intrinsic amorphous silicon may be in a range of 2 nm to 8 nm, the reactive gas may include SiH₄ and H₂, the flow ratio of H₂ to SiH₄ may be 5, the power density of the power supply of the PECVD device may be 20 mW/cm², the pressure inside the PECVD device may be 70Pa, and the substrate temperature may be 200 °C. Step 103 further includes that depositing the P-type doped amorphous silicon layer on the second intrinsic amorphous silicon by the PECVD method, a thickness of the P-type doped amorphous silicon layer may be in a range of 4 nm to 30 nm, the reactive gas may include SiH₄, B₂H₆, and H₂, the flow ratio of H₂ to SiH₄ may be 4, a flow ratio of B₂H₆ to SiH₄ may be 0.04, the power density of the power supply of the PECVD device may be 15 mW/cm², the pressure inside the PECVD device may be 60Pa, and the substrate temperature may be 200 °C.

Step 104 includes that depositing the first transparent conductive layer on the N-type doped amorphous silicon layer by a Physical Vapor Deposition (PVD) method, and depositing the second transparent conductive layer on the P-type doped amorphous silicon layer by the PVD method. A thickness of the first transparent conductive layer may be in a range of 70 nm to 120 nm, and a thickness of the second transparent conductive layer may be in a range of 70 nm to 120 nm. Both the first transparent conductive layer and the second transparent conductive layer may be ITO transparent conductive films, a mass percentage of indium elements in the ITO each may be 90%, and a mass percentage of tin elements in the ITO each may be 10%. A PVD device may be charged with Ar and O₂. A flow ratio of O2 to Ar may be 0.025, a pressure inside the PVD device may be 0.5Pa, and the substrate temperature may be room temperature.

Step 105 includes that placing a mask plate on a surface of either or both of the first transparent conductive layer and the second transparent conductive layer, performing local cleaning and reduction on the transparent conductive layer by hydrogen plasma processing, and obtaining a local reduction layer with relatively increased local carrier concentration. An opening pattern of the mask plate may be the same as a metal electrode pattern, a width of the local reduction layer may be in a range of 5 µm to 50 µm, alternatively in a range of 30 µm to 50 µm, and the carrier concentration of the local reduction layer may be greater than that of either or both of the first transparent conductive layer and the second transparent conductive layer.

Step 106 includes that forming the first metal electrode on the first transparent conductive layer by screen printing, and forming the second metal electrode on the second transparent conductive layer by screen printing. A metal electrode pattern of the first metal electrode and a metal electrode pattern of the second metal electrode may be the same as the opening pattern of the mask plate, and either or both of the first metal electrode and the second metal electrode may be located at a position directly above the local reduction layer, respectively.

In some embodiments of the present invention, the mask plate may be disposed on the surface of the transparent conductive layer, the opening pattern of the mask plate may be consistent with the metal electrode pattern, and then hydrogen plasma processing may be used to perform local cleaning and reduction on the transparent conductive layer, so as to obtain a local reduction layer with relatively increased local carrier concentration.

In the present invention, the surface of the crystalline silicon layer may include the front surface of the crystalline silicon layer, the back surface of the crystalline silicon layer, or a combination thereof.

In some embodiments of the present invention, the texturing additive may be a conventional texturing additive in the related art. In some embodiments of the present invention, the texturing additive may include an alkaline mixture, which may include components such as an alkali, a surfactant, a weak acid salt, and water.

In some embodiments of the present invention, the mask plate may be a conventional mask plate in the related art. In some embodiments of the present invention, the mask plate may include a mask plate of a resin substrate or a mask plate of a glass substrate.

In some embodiments of the present invention, an RCA standard cleaning method may be applied to clean the crystalline silicon layer obtained after texturing. The RCA standard cleaning method may include following steps.
(1) Pre-cleaning: mixing hydrogen peroxide, ammonia and deionized water, which are configured to remove residual organic matter on the surface of the silicon chip.
(2) Alkali throwing: mixing potassium hydroxide and deionized water, and dissolving double-sided surface layers of the silicon wafer with the potassium hydroxide for 5 µm to 25µm.
(3) Texturing: mixing potassium hydroxide, the texturing additive, and deionized water to form a surface covered with a pyramid textured morphology.
(4) Circulation: mixing hydrofluoric acid, ozone, and deionized water, and removing and rounding pyramid spikes and bottoms.
(5) Post-cleaning: mixing hydrogen peroxide, hydrochloric acid, and deionized water, which are configured to remove metal impurities remaining on the surface of the silicon wafer.
(6) Hydrophobicity: mixing hydrofluoric acid and deionized water, and removing silicon oxide on the surface of the silicon wafer by hydrofluoric acid, and forming a hydrophobicity layer on the surface of the silicon wafer.
(7) Bath washing: soaking and rinsing with deionized water after each step of steps 1 to 6.
(8) Drying: after step 6, drying the silicon wafer with hot air.

### A first embodiment

A preparation method for the heterojunction battery may include following step one to step six.

Step one includes that providing a crystalline silicon layer. A N-type straight-pull monocrystalline silicon wafer may be applied, a thickness of the N-type straight-pull monocrystalline silicon wafer may be 150 µm, a resistivity of the N-type straight-pull monocrystalline silicon wafer may be 3Ω·cm, and a minority carrier life of the N-type straight-pull monocrystalline silicon wafer may be 2000 µs.

Step two includes that texturing a surface of the crystalline silicon layer, and cleaning the surface of the crystalline silicon layer. A mixed solution of NaOH and a texturing additive may be used to texture the silicon wafer, then surface cleaning may be performed on the silicon wafer by a RCA standard cleaning method, to remove surface-contaminated impurities, and a surface oxide layer may be removed by a hydrofluoric acid solution.

Step three includes that depositing the first intrinsic amorphous silicon on the front surface of the crystalline silicon layer by a PECVD method, a thickness of the first intrinsic amorphous silicon may be 6 nm, reactive gas may include SiH₄ and H₂, a flow ratio of H₂ to SiH₄ may be 5, a power density of a power supply of a PECVD device may be 20 mW/cm², a pressure inside the PECVD device may be 70Pa, and a substrate temperature may be 200 °C. Step three further includes that depositing the N-type doped amorphous silicon layer on the first intrinsic amorphous silicon by the PECVD method, a thickness of the N-type doped amorphous silicon layer may be 6 nm, the reactive gas may include SiH₄, H₂, and PH₃, the flow ratio of H₂ to SiH₄ may be 5, a flow ratio of PH₃ to SiH₄ may be 0.02, the power density of the power supply of the PECVD device may be 15 mW/cm², the pressure inside the PECVD device may be 80Pa, and the substrate temperature may be 200 °C. Step three further includes that depositing the second intrinsic amorphous silicon on the back surface of the crystalline silicon layer by the PECVD method, a thickness of the second intrinsic amorphous silicon may be 7 nm, the reactive gas may include SiH₄ and H₂, the flow ratio of H₂ to SiH₄ may be 5, the power density of the power supply of the PECVD device may be 20 mW/cm², the pressure inside the PECVD device may be 70Pa, and the substrate temperature may be 200 °C. Step three further includes that depositing the P-type doped amorphous silicon layer on the second intrinsic amorphous silicon by the PECVD method, a thickness of the P-type doped amorphous silicon layer may be 10 nm, the reactive gas may include SiH₄, B₂H₆, and H₂, the flow ratio of H₂ to SiH₄ may be 4, a flow ratio of B₂H₆ to SiH₄ may be 0.04, the power density of the power supply of the PECVD device may be 15 mW/cm², the pressure inside the PECVD device may be 60Pa, and the substrate temperature may be 200 °C.

Step four includes that depositing the first transparent conductive layer on the N-type doped amorphous silicon layer by a PVD method, and depositing the second transparent conductive layer on the P-type doped amorphous silicon layer by the PVD method. A thickness of the first transparent conductive layer may be 75 nm, and a thickness of the second transparent conductive layer may be 75 nm. Both the first transparent conductive layer and the second transparent conductive layer may be ITO transparent conductive films, a mass percentage of indium elements in the ITO each may be 90%, and a mass percentage of tin elements in the ITO each may be 10%. A PVD device may be charged with Ar and O₂. A flow ratio of O2 to Ar may be 0.025, a pressure inside the PVD device may be 0.5Pa, and the substrate temperature may be room temperature.

Step five includes that placing a mask plate on surfaces of both of the first transparent conductive layer and the second transparent conductive layer, respectively, performing local cleaning and reduction on the transparent conductive layer by hydrogen plasma processing, and obtaining a local reduction layer with relatively increased local carrier concentration. An opening pattern of the mask plate may be the same as a metal electrode pattern, a width of the local reduction layer may be 30 µm, and the carrier concentration of the local reduction layer may be greater than that of both of the first transparent conductive layer and the second transparent conductive layer.

Step six includes that forming the first metal electrode on the first transparent conductive layer by screen printing, and forming the second metal electrode on the second transparent conductive layer by screen printing. A metal electrode pattern of the first metal electrode and a metal electrode pattern of the second metal electrode may be the same as the opening pattern of the mask plate, and both of the first metal electrode and the second metal electrode may be located at a position directly above the local reduction layer, respectively.

### A second embodiment

A preparation method for the heterojunction battery may include following step one to step six.

Step one includes that providing a crystalline silicon layer. A N-type straight-pull monocrystalline silicon wafer may be applied, a thickness of the N-type straight-pull monocrystalline silicon wafer may be 100 µm, a resistivity of the N-type straight-pull monocrystalline silicon wafer may be 3Ω·cm, and a minority carrier life of the N-type straight-pull monocrystalline silicon wafer may be 2000 µs.

Step two includes that texturing a surface of the crystalline silicon layer, and cleaning the surface of the crystalline silicon layer. A mixed solution of NaOH and a texturing additive may be used to texture the silicon wafer, then surface cleaning may be performed on the silicon wafer by a RCA standard cleaning method, to remove surface-contaminated impurities, and a surface oxide layer may be removed by a hydrofluoric acid solution.

Step three includes that depositing the first intrinsic amorphous silicon on the front surface of the crystalline silicon layer by a PECVD method, a thickness of the first intrinsic amorphous silicon may be 5 nm, reactive gas may include SiH₄ and H₂, a flow ratio of H₂ to SiH₄ may be 5, a power density of a power supply of a PECVD device may be 20 mW/cm², a pressure inside the PECVD device may be 70Pa, and a substrate temperature may be 200 °C. Step three further includes that depositing the N-type doped amorphous silicon layer on the first intrinsic amorphous silicon by the PECVD method, a thickness of the N-type doped amorphous silicon layer may be 8 nm, the reactive gas may include SiH₄, H₂, and PH₃, the flow ratio of H₂ to SiH₄ may be 5, a flow ratio of PH₃ to SiH₄ may be 0.02, the power density of the power supply of the PECVD device may be 15 mW/cm², the pressure inside the PECVD device may be 80Pa, and the substrate temperature may be 200 °C. Step three further includes that depositing the second intrinsic amorphous silicon on the back surface of the crystalline silicon layer by the PECVD method, a thickness of the second intrinsic amorphous silicon may be 7 nm, the reactive gas may include SiH₄ and H₂, the flow ratio of H₂ to SiH₄ may be 5, the power density of the power supply of the PECVD device may be 20 mW/cm², the pressure inside the PECVD device may be 70Pa, and the substrate temperature may be 200 °C. Step three further includes that depositing the P-type doped amorphous silicon layer on the second intrinsic amorphous silicon by the PECVD method, a thickness of the P-type doped amorphous silicon layer may be 10 nm, the reactive gas may include SiH₄, B₂H₆, and H₂, the flow ratio of H₂ to SiH₄ may be 4, a flow ratio of B₂H₆ to SiH₄ may be 0.04, the power density of the power supply of the PECVD device may be 15 mW/cm², the pressure inside the PECVD device may be 60Pa, and the substrate temperature may be 200 °C.

Step four includes that depositing the first transparent conductive layer on the N-type doped amorphous silicon layer by a PVD method, and depositing the second transparent conductive layer on the P-type doped amorphous silicon layer by the PVD method. A thickness of the first transparent conductive layer may be 100 nm, and a thickness of the second transparent conductive layer may be 100 nm. Both the first transparent conductive layer and the second transparent conductive layer may be ITO transparent conductive films, a mass percentage of indium elements in the ITO each may be 90%, and a mass percentage of tin elements in the ITO each may be 10%. A PVD device may be charged with Ar and O₂. A flow ratio of O2 to Ar may be 0.025, a pressure inside the PVD device may be 0.5Pa, and the substrate temperature may be room temperature.

Step five includes that placing a mask plate on a surface of the first transparent conductive layer, performing local cleaning and reduction on the transparent conductive layer by hydrogen plasma processing, and obtaining a local reduction layer with relatively increased local carrier concentration. An opening pattern of the mask plate may be the same as a metal electrode pattern, a width of the local reduction layer may be 30 µm, and the carrier concentration of the local reduction layer may be greater than that of the first transparent conductive layer.

Step six includes that forming the first metal electrode on the first transparent conductive layer by screen printing, and forming the second metal electrode on the second transparent conductive layer by screen printing. A metal electrode pattern of the first metal electrode may be the same as the opening pattern of the mask plate, and the first metal electrode may be located at a position directly above the local reduction layer.

### A third embodiment

A preparation method for the heterojunction battery may include following step one to step six.

Step one includes that providing a crystalline silicon layer. A P-type straight-pull monocrystalline silicon wafer may be applied, a thickness of the P-type straight-pull monocrystalline silicon wafer may be 150 µm, a resistivity of the P-type straight-pull monocrystalline silicon wafer may be 3Ω·cm, and a minority carrier life of the P-type straight-pull monocrystalline silicon wafer may be 2000 µs.

Step two includes that texturing a surface of the crystalline silicon layer, and cleaning the surface of the crystalline silicon layer. A mixed solution of NaOH and a texturing additive may be used to texture the silicon wafer, then surface cleaning may be performed on the silicon wafer by a RCA standard cleaning method, to remove surface-contaminated impurities, and a surface oxide layer may be removed by a hydrofluoric acid solution.

Step three includes that depositing the first intrinsic amorphous silicon on the front surface of the crystalline silicon layer by a PECVD method, a thickness of the first intrinsic amorphous silicon may be 5 nm, reactive gas may include SiH₄ and H₂, a flow ratio of H₂ to SiH₄ may be 5, a power density of a power supply of a PECVD device may be 20 mW/cm², a pressure inside the PECVD device may be 70Pa, and a substrate temperature may be 200 °C. Step three further includes that depositing the N-type doped amorphous silicon layer on the first intrinsic amorphous silicon by the PECVD method, a thickness of the N-type doped amorphous silicon layer may be 8 nm, the reactive gas may include SiH₄, H₂, and PH₃, the flow ratio of H₂ to SiH₄ may be 5, a flow ratio of PH₃ to SiH₄ may be 0.02, the power density of the power supply of the PECVD device may be 15 mW/cm², the pressure inside the PECVD device may be 80Pa, and the substrate temperature may be 200 °C. Step three further includes that depositing the second intrinsic amorphous silicon on the back surface of the crystalline silicon layer by the PECVD method, a thickness of the second intrinsic amorphous silicon may be 7 nm, the reactive gas may include SiH₄ and H₂, the flow ratio of H₂ to SiH₄ may be 5, the power density of the power supply of the PECVD device may be 20 mW/cm², the pressure inside the PECVD device may be 70Pa, and the substrate temperature may be 200 °C. Step three further includes that depositing the P-type doped amorphous silicon layer on the second intrinsic amorphous silicon by the PECVD method, a thickness of the P-type doped amorphous silicon layer may be 10 nm, the reactive gas may include SiH₄, B₂H₆, and H₂, the flow ratio of H₂ to SiH₄ may be 4, a flow ratio of B₂H₆ to SiH₄ may be 0.04, the power density of the power supply of the PECVD device may be 15 mW/cm², the pressure inside the PECVD device may be 60Pa, and the substrate temperature may be 200 °C.

Step four includes that depositing the first transparent conductive layer on the N-type doped amorphous silicon layer by a PVD method, and depositing the second transparent conductive layer on the P-type doped amorphous silicon layer by the PVD method. A thickness of the first transparent conductive layer may be 100 nm, and a thickness of the second transparent conductive layer may be 100 nm. Both the first transparent conductive layer and the second transparent conductive layer may be ITO transparent conductive films, a mass percentage of indium elements in the ITO each may be 90%, and a mass percentage of tin elements in the ITO each may be 10%. A PVD device may be charged with Ar and O₂. A flow ratio of O2 to Ar may be 0.025, a pressure inside the PVD device may be 0.5Pa, and the substrate temperature may be room temperature.

Step five includes that placing a mask plate on a surface of the second transparent conductive layer, performing local cleaning and reduction on the transparent conductive layer by hydrogen plasma processing, and obtaining a local reduction layer with relatively increased local carrier concentration. An opening pattern of the mask plate may be the same as a metal electrode pattern, a width of the local reduction layer may be 30 µm, and the carrier concentration of the local reduction layer may be greater than that of the second transparent conductive layer.

Step six includes that forming the first metal electrode on the first transparent conductive layer by screen printing, and forming the second metal electrode on the second transparent conductive layer by screen printing. A metal electrode pattern of the second metal electrode may be the same as the opening pattern of the mask plate, and the second metal electrode may be located at a position directly above the local reduction layer.

The present invention has following advantages.
(1) A local reduction layer is formed on a surface of a transparent conductive layer below a cryogenic metal slurry electrode, local carrier concentration of the transparent conductive layer is increased, and an interface barrier height between the transparent conductive layer and the cryogenic metal slurry electrode is reduced to obtain a relatively low contact resistance. **In** addition, the locally treated surface is cleaner and is not affected by adsorption of water vapor, oxygen, and organic in the air.
(2) The mask plate may be disposed on the surface of the transparent conductive layer, the opening pattern of the mask plate may be consistent with the metal electrode pattern, and then hydrogen plasma processing may be used to perform local cleaning and reduction on the transparent conductive layer, so as to obtain a local reduction layer with relatively increased local carrier concentration.

The technical features in the foregoing embodiments may be combined randomly. To make the description brief, all possible combinations of the technical features in the foregoing embodiments are not described. However, as long as there is no contradiction between the combinations of the technical features, it should be considered as the scope described in this description.

The foregoing embodiments represent only several implementation manners of the present invention, and descriptions thereof are relatively specific and detailed, but may not be construed as a limitation on the scope of patent protection. It should be noted that one skilled in the art may make some modifications and improvements without departing from the concept of the present invention, which are within the protection scope of the present invention. Therefore, the protection scope of the present invention shall be subject to the attached claims.

## Claims

1. A heterojunction battery, **characterized by** comprising a crystalline silicon layer,
wherein a first intrinsic amorphous silicon layer, a N-type doped amorphous silicon layer, a first transparent conductive layer, and a first metal electrode are sequentially arranged on a front surface of the crystalline silicon layer from inside to outside;
a second intrinsic amorphous silicon layer, a P-type doped amorphous silicon layer, a second transparent conductive layer, and a second metal electrode are sequentially arranged on a back surface of the crystalline silicon layer from inside to outside;
a local reduction layer is formed on either or both of a surface of the first transparent conductive layer that is under the first metal electrode and a surface of the second transparent conductive layer that is under the second metal electrode; and
a carrier concentration of the local reduction layer is greater than that of either or both of the first transparent conductive layer and the second transparent conductive layer.

2. The heterojunction battery of claim 1, wherein a width of the local reduction layer is in a range of 5 µm to 50 µm.

3. The heterojunction battery of claim 1, wherein the crystalline silicon layer is selected from N-type doped monocrystalline silicon, N-type doped quasi monocrystalline silicon, P-type doped monocrystalline silicon, or P-type doped quasi monocrystalline silicon, and a thickness of the crystalline silicon layer is in a range of 50 µm to 250 µm.

4. The heterojunction battery of claim 1, wherein the first intrinsic amorphous silicon layer comprises an undoped amorphous silicon semiconductor film, an amorphous silicon oxide semiconductor film, an amorphous silicon carbide semiconductor film, or a composite film layer formed by a combination thereof, and a thickness of the first intrinsic amorphous silicon layer is in a range of 2 nm to 8 nm.

5. The heterojunction battery of claim 1, wherein the N-type doped amorphous silicon layer comprises a N-type doped amorphous silicon semiconductor film, a N-type doped amorphous silicon oxide semiconductor film, a N-type doped amorphous silicon carbide semiconductor film, a N-type doped microcrystalline silicon semiconductor film, a N-type doped microcrystalline silicon oxide semiconductor film, a N-type doped microcrystalline silicon carbide semiconductor film, or a composite film layer formed by a combination thereof, and a thickness of the N-type doped amorphous silicon layer is in a range of 4 nm to 30 nm.

6. The heterojunction battery of claim 1, wherein the P-type doped amorphous silicon layer comprises a P-type doped amorphous silicon semiconductor film, a P-type doped amorphous silicon oxide semiconductor film, a P-type doped amorphous silicon carbide semiconductor film, a P-type doped microcrystalline silicon semiconductor film, a P-type doped microcrystalline silicon oxide semiconductor film, a P-type doped microcrystalline silicon carbide semiconductor film, or a composite film layer formed by a combination thereof, and a thickness of the P-type doped amorphous silicon layer is in a range of 4 nm to 30 nm.

7. The heterojunction battery of claim 1, wherein the first transparent conductive layer comprises a doped indium oxide film, a doped zinc oxide film, a doped tin oxide film, or a composite film layer formed by a combination thereof, and a thickness of the first transparent conductive layer is in a range of 70 nm to 120 nm.

8. The heterojunction battery of claim 1, wherein the second transparent conductive layer comprises a doped indium oxide film, a doped zinc oxide film, a doped tin oxide film, or a composite film layer formed by a combination thereof, and a thickness of the second transparent conductive layer is in a range of 70 nm to 120 nm.

9. The heterojunction battery of claim 7, wherein both the first transparent conductive layer and the second transparent conductive layer are indium tin oxide transparent conductive films, a mass percentage of indium elements in the first transparent conductive layer and the second transparent conductive layer each is 90%, and a mass percentage of tin elements in the first transparent conductive layer and the second transparent conductive layer each is 10%.

10. The heterojunction battery of claim 1, wherein the first metal electrode comprises a cryogenic metal slurry electrode containing Ag, Cu, Al, Ni or a combination thereof, a thickness of the first metal electrode is in a range of 10 µm to 50 µm, and a width of the first metal electrode is in a range of 5 µm to 50 µm.

11. The heterojunction battery of claim 1, wherein the second metal electrode comprises a cryogenic metal slurry electrode containing Ag, Cu, Al, Ni or a combination thereof, a thickness of the second metal electrode is in a range of 10 µm to 50 µm, and a width of the second metal electrode is in a range of 5 µm to 50 µm.

12. A preparation method for a heterojunction battery, **characterized by** comprising:
step one: providing a crystalline silicon layer;
step two: texturing a surface of the crystalline silicon layer, and cleaning the surface of the crystalline silicon layer;
step three: depositing a first intrinsic amorphous silicon and a N-type doped amorphous silicon layer sequentially on a front surface of the crystalline silicon layer obtained in the step two, and depositing a second intrinsic amorphous silicon and a P-type doped amorphous silicon layer sequentially on a back surface of the crystalline silicon layer obtained in the step two;
step four: depositing a first transparent conductive layer on the N-type doped amorphous silicon layer obtained in the step three, and depositing a second transparent conductive layer on the P-type doped amorphous silicon layer obtained in the step three;
step five: placing a mask plate on a surface of either or both of the first transparent conductive layer and the second transparent conductive layer, performing local cleaning and reduction on the transparent conductive layer by hydrogen plasma processing, and obtaining a local reduction layer with relatively increased local carrier concentration, wherein a width of the local reduction layer is in a range of 5 µm to 50 µm; and
step six: forming a first metal electrode on the first transparent conductive layer by screen printing, and forming a second metal electrode on the second transparent conductive layer by screen printing, wherein a metal electrode pattern of the first metal electrode and a metal electrode pattern of the second metal electrode are the same as an opening pattern of the mask plate, and either or both of the first metal electrode and the second metal electrode is located at a position directly above the local reduction layer, respectively.

13. The preparation method of claim 12, wherein the width of the local reduction layer is in a range of 30 µm to 50 µm.

14. The preparation method of claim 12, wherein the step three further comprises: depositing the first intrinsic amorphous silicon and the N-type doped amorphous silicon layer sequentially on the front surface of the crystalline silicon layer obtained in the step two by a plasma enhanced chemical vapor deposition method, and depositing the second intrinsic amorphous silicon and the P-type doped amorphous silicon layer sequentially on the back surface of the crystalline silicon layer obtained in the step two by the plasma enhanced chemical vapor deposition method; and
the step four further comprises: depositing the first transparent conductive layer on the N-type doped amorphous silicon layer obtained in the step three by a physical vapor deposition method, and depositing the second transparent conductive layer on the P-type doped amorphous silicon layer obtained in the step three by the physical vapor deposition method.

15. A photovoltaic assembly, **characterized by** comprising the heterojunction battery of any one of claims 1 to 11.
